Europäisches Patentamt

(19) European Patent Office

Office européen des brevets

(11) Publication number: **0 258 312 B1**

## (12) EUROPEAN PATENT SPECIFICATION

(45) Date of publication of patent specification:
20.02.91 Bulletin 91/08

(51) Int. Cl.⁵: **H05K 7/20, H01L 23/40**

(21) Application number: 87901224.3

(22) Date of filing: 27.01.87

(86) International application number:
PCT/US87/00159

(87) International publication number:
WO 87/05183 27.08.87 Gazette 87/19

(54) MOUNTING ARRANGEMENT FOR SOLID STATE DEVICES.

(30) Priority: 18.02.86 US 830026

(43) Date of publication of application:
09.03.88 Bulletin 88/10

(45) Publication of the grant of the patent:
20.02.91 Bulletin 91/08

(84) Designated Contracting States:
AT BE CH DE FR GB LI

(56) References cited:
EP-A- 0 124 715
DE-A- 3 331 207
DE-A- 3 416 348
US-A- 4 204 248
US-A- 4 475 145

(73) Proprietor: NCR CORPORATION
World Headquarters
Dayton, Ohio 45479 (US)

(72) Inventor: FAA, Leland, Milford, Jr.
1634-A Riverwind Drive
Columbia, SC 29210 (US)

(74) Representative: Robinson, Robert George
International Patent Department NCR Limited
206 Marylebone Road
London NW1 6LY (GB)

## Description

### Technical Field

This invention relates to mounting means for a solid state device, of the kind including a thermally conductive support body adapted to contact a heat sink, wherein said thermally conductive support body has a substantially L-shaped cross-section and includes first and second legs, said first leg being adapted to contact said heat sink and said second leg extending from said first leg and having a flat surface.

### Background Art

Present day solid state devices, for example solid state devices used in power supplies, generate amounts of heat which cannot be adequately transferred to the ambient surroundings without the utilization of a heat sink. It is known to use printed circuit boards to provide a support for the electrical conductors and the associated electrical components such as solid state devices. However, a problem arises in mounting solid state devices so as to connect thermally with a heat sink and simultaneously to connect electrically with conductors on a printed circuit board.

Mounting means of the kind specified is known from U.S. Patent No. 4,204,248. In the known means, a solid state device is attached to a support body by a threaded screw which extends through aligned holes in the device and in the support body. An extension of the support body is attached by a threaded screw to a chassis which serves as a heat sink. Leads from the solid state device are soldered to conductors on a printed circuit board which is attached to the chassis by a further threaded screw. Heat generated by the solid state device is conducted via the support to be dissipated by the chassis.

It will be appreciated that in mounting means according to the invention, thermal contact is made with two surfaces of the solid state device, whereby large heat transfer is achieved. Furthermore, the arrangement of mating angled surfaces provides a strong clamping pressure for firmly maintaining the solid state device in position, while permitting easy removal of a defective device when necessary, without disruption to other mounted devices. The mounting means can be utilized to provide a quick and strong mount for solid state devices in close proximity to a printed circuit board.

### Brief Description of the Drawings

One embodiment of the present invention will now be described by way of example, with reference to the accompanying drawings, in which : serving as a heat sink. However, the amount of heat which can be conducted away from the solid state device is limited.

### Disclosure of the Invention

It is an object of the present invention to provide mounting means of the kind specified having improved heat transfer characteristics.

Therefore, according to the present invention, there is provided mounting means of the kind specified, characterized in that said second leg has an angled end portion forming an angle of less than 90° with said flat surface ; in that a thermally conductive cap member having a substantially L-shaped cross-section is provided having third and fourth legs, said fourth leg having an angled surface adapted to mate with said angled end portion such that said third leg is substantially parallel to said flat surface ; and in that urging means are provided on the mating surfaces of said second and fourth legs, adapted to urge said third leg towards said flat surface, whereby said solid state device may be mounted between and in thermal contact with said flat surface of said second leg and said third leg of said cap member, such that said fourth leg is substantially parallel to said first leg.

Fig. 1 is a perspective view, partially in exploded form, of the preferred embodiment of the invention ; and

Fig. 2 is an end view of the preferred embodiment of the invention, partly in section.

### Best Mode for Carrying Out the Invention

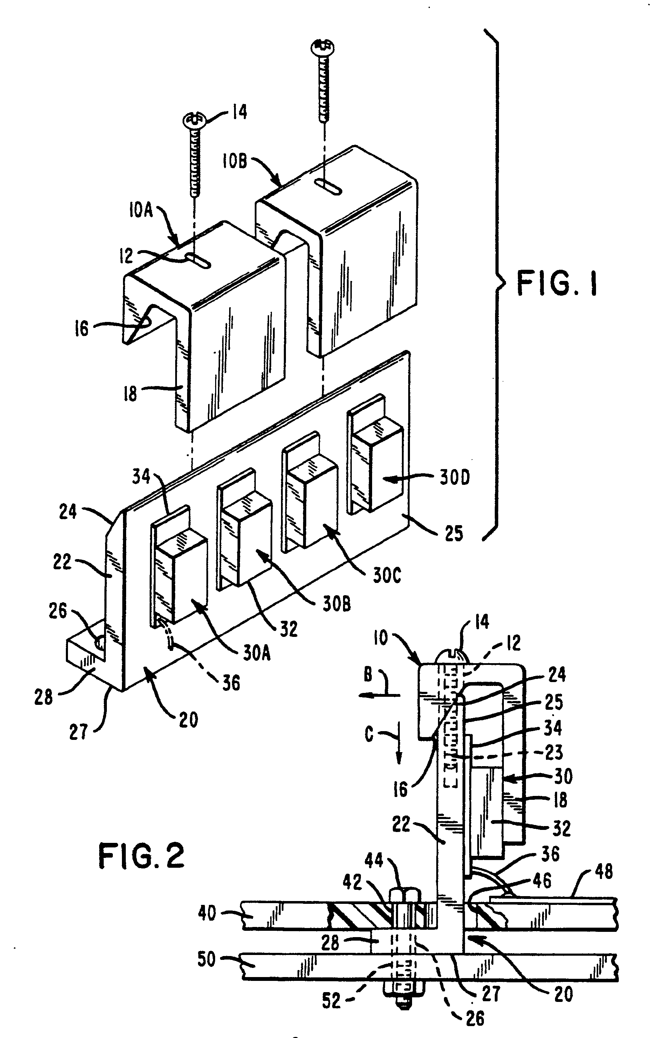

Referring to Fig. 1, an elongated thermally conductive, support body 20 is shown having a substantially L-shaped cross section formed by a pair of legs 28 and 22, with leg 22 extending at a right angle from leg 28 and having an angled end portion 24. The legs 22, 28 may be of approximately equal length or, as shown in the drawings, of different lengths. In the preferred embodiment of the invention, the angle of the end portion is approximately 30 degrees. Leg 22 has a first flat surface 25 and leg 28 has a second flat surface 27. Each of a plurality of thermally conductive cap members 10 (shown individually in Fig. 1 as 1OA, 1OB) has an L-shaped cross section, and one leg thereof is provided with an angled surface 16 that is designed to mate with the angled end portion 24. An elongated opening 12, in each cap member 10, is adapted to receive a fastener, which may be a bolt 14. The bolt 14 contacts a receptacle in the form of a threaded opening 23 in the leg 22 (shown in Fig. 2). Each cap member 10, in the preferred embodiment of the invention, was of a width that permitted two solid state devices 30 to be mounted by the cap member. The solid state devices 30 are shown individually as 30A-30D in Fig. 1. The cap members 10 may be made wider or narrower in width to permit either more or less solid state devices 30 to be mounted by each cap member.

Each solid state device 30, in the preferred embodiment, is comprised of a body section 32, a flat heat transfer plate 34, and electrical conductors (leads) 36. The leads 36 extend from the solid state device to conductors 48 on an associated printed circuit board 40 (shown in Fig. 2).

Referring now to Fig. 2, a metallic chassis 50 provides the major heat sink to which the thermally conductive support body 20 is attached. The leg 28 is provided with an opening 26 through which a fastener 44 is inserted and which fastener also passes through an opening 42 in a printed circuit board 40 and an opening 52 in the chassis 50. The leg 22 extends through an opening 46 in the printed circuit board 40. The fastener 44 holds the second flat surface 27 of leg 28 in thermal contact with the chassis body 50, while also holding the printed circuit board 40 in a fixed relationship with respect to the chassis 50 and the support body 20.

To assemble, the solid state device 30 is positioned between the leg 18 of cap member 10 and the first flat surface 25 of the leg 22. As the bolt 14 is tightened downwards into the threaded opening 23 of the leg 22, the angled surface 16 slides downwards at an angle which causes the cap member 10 to move in the direction indicated by the direction of arrow B and in the direction indicated by the direction of arrow C. Movement in the B direction causes a force to be transmitted to the solid state device 30, which urges the heat transfer plate 34 into contact with the first flat surface 25 of the leg 22. Once mounted in this sandwiched fashion, the solid state device can transmit heat upwards through the leg 18 and then down through the leg 22 and through heat transfer plate 34 to the leg 22, and hence downward into the chassis 50.

The leads 36 are soldered to the corresponding conductors 48 on the circuit board 40 and if necessary, to remove a defective solid state device the leads 36, can be easily de-soldered and the bolt 14 disengaged so that the defective component can be removed and a new component installed.

In the preferred embodiment of the invention, the support member 20 and the cap members 10 were formed of aluminum which aluminum was finished black anodized.

## Claims

1. Mounting means for a solid state device (30) including a thermally conductive support body (20) adapted to contact a heat sink (50), wherein said thermally conductive support body (20) has a substantially L-shaped cross-section and includes first (28) and second (22) legs, said first leg (28) being adapted to contact said heat sink (50) and said second leg (22) extending from said first leg (28) and having a flat surface (25), characterized in that said second leg (22) has an angled end portion (24) forming an angle of less than 90 degress with said flat surface (25) ; in that a thermally conductive cap member (10) having a substantially L-shaped cross-section is provided having third (18) and fourth legs, said fourth leg having an angled surface (16) adapted to mate with said angled end portion (24) such that said third leg (18) is substantially parallel to said flat surface (25) ; and in that urging means (14) are provided on the mating surfaces (16, 24) of said second (22) and fourth legs, adapted to urge said third leg (18) towards said flat surface (25), whereby said solid state device (30) may be mounted between and in thermal contact with said flat surface (25) of said second leg (22) and said third leg (18) of said cap member (10), such that said fourth leg is substantially parallel to said first leg (28).

2. Mounting means according to claim 1, characterized in that said second leg (22) extends from said first leg (28) at substantially a right angle.

3. Mounting means according to claim 1, characterized in that said cap member (10) has an elongated opening (12) through said fourth leg, in that said second leg (22) has a fastener receptacle (23) formed therein, and in that said urging means including a fastener (14) which extends through said elongated opening (12) in said fourth leg to engage said fastener receptacle (23) and thereby urge said third leg (18) towards said flat surface (25).

4. Mounting means according to claim 1, characterized in that said first leg (28) has a further flat surface (27) adapted to contact said heat sink (50).

5. Mounting means according to claim 1, characterized in that said heat sink includes a metallic chassis (50) ; by a printed circuit board (40) having conductors (48) thereon adapted to be connected to electrical leads (36) extending from said solid state device (30) and having an opening (46) therethrough for allowing said second leg (22) to pass therethrough ; and by fastener means (44) adapted to mount said printed circuit board (40) and said support body (20) to said metallic chassis (50) such that said solid state device (30) is located adjacent said conductors (48).

6. Mounting means according to claim 1, characterized in that a plurality of solid state devices (30A, 30B) are mounted between said support body (20) and said cap member (10A).

## Ansprüche

1. Halterungsvorrichtung für eine Festkörpervorrichtung (30) mit einem wärmeleitenden Abstützungskörper (20), der mit einer Wärmesenke (50) in Kontakt gehen kann, wobei der wärmeleitende Abstützungskörper (20) einen im wesentlichen L-förmigen Querschnitt hat und einen ersten (28) und einen zweiten (22) Schenkel aufweist, wobei der erste Schenkel (28) geeignet ist, mit der Wärmesenke (50) in Kontakt zu gehen, und der zweit Schenkel (22) sich von dem ersten Schenkel (28) wegerstreckt und eine ebene Fläche (25) besitzt, dadurch gekennzeichnet, daß der zweite Schenkel (22) einen gewinkelten Endabschnitt (24) aufweist, der einen Winkel von weniger als 90° mit der ebenen Fläche (25) einschließt ; daß ein thermisch leitendes Kappenelement (10) mit im wesentlichen L-förmigem Querschnitt vorgesehen ist, das einen dritten (18) und einen vierten Schenkel aufweist, wobei der vierte Schenkel eine gewinkelte Fläche (16) besitzt, die geeignet ist, mit dem gewinkelten Endabschnitt (24) in passenden Eingriff zu gehen, derart, daß der dritte Schenkel (18) im wesentlichen parallel zu der ebenen Fläche (25) ist ; und daß eine Druckvorrichtung (14) an den zueinander passenden Flächen (16, 24) des zweiten (22) und vierten Schenkels vorgesehen ist, die geeignet ist, den dritten Schenkel (18) in Richtung der ebenen Fläche (25) zu drücken, so daß die Festkörpervorrichtung (30) zwischen und in Wärmekontakt mit der ebenen Fläche (25) des zweiten Schenkels (22) und des dritten Schenkels (18) des Kappenelements (10) derart befestigt werden kann, daß der vierte Schenkel im wesentlichen parallel zum ersten Schenkel (28) verläuft.

2. Halterungsvorrichtung nach Anspruch 1, dadurch gekennzeichnet, daß der zweite Schenkel (22) sich von dem ersten Schenkel (28) im wesentlichen unter einem rechten Winkel erstreckt.

3. Halterungsvorrichtung nach Anspruch 1, dadurch gekennzeichnet, daß das Kappenelement (10) eine längliche Öffnung (12) durch den vierten Schenkel aufweist, daß in dem zweiten Schenkel (22) eine Befestigungselementaufnahme (23) ausgebildet ist, daß die Druckvorrichtung ein Befestigungselement (14) aufweist, das sich durch die längliche Öffnung (12) im vierten Schenkel erstreckt, um in Eingriff mit der Befestigungselementaufnahme (23) zu gehen und hierdurch den dritten Schenkel (18) in Richtung der ebenen Fläche (25) zu drücken.

4. Halterungsvorrichtung nach Anspruch 1, dadurch gekennzeichnet, daß der erste Schenkel (28) eine weitere ebene Fläche (27) aufweist, die geeignet ist, mit der Wärmesenke (50) in Kontakt zu gehen.

5. Halterungsvorrichtung nach Anspruch 1, dadurch gekennzeichnet, daß die Wärmesenke ein metallisches Chassis (50) aufweist ; durch eine gedruckte Schaltungsplatte (40), die Leiter (48) darauf aufweist, die geeignet sind, mit elektrischen Leitern (36) verbunden zu werden, die sich von der Festkörpervorrichtung (30) erstrecken, und eine Öffnung (46) hindurch aufweist, durch die der zweite Schenkel (22) geführt werden kann ; und durch eine Befestigungselementvorrichtung (44), die geeignet ist, die gedruckte Schaltungsplatte (40) und den Abstützungskörper (20) an dem metallischen Chassis (50) derart zu halten, daß die Festkörpervorrichtung (30) benachbart zu den Leitern (48) angeordnet ist.

6. Halterungsvorrichtung nach Anspruch 1, dadurch gekennzeichnet, daß eine Vielzahl von Festkörpervorrichtungen (30A, 30B) zwischen dem Abstützungskörper (20) und dem Kappenelement (10A) angeordnet sind.

## Revendications

1. Moyens de montage pour un dispositif (30) à semiconducteur, comprenant un corps de support (20) conducteur de la chaleur conçu pour être en contact avec un radiateur thermique (50), dans lesquels ledit corps de support (20) conducteur de la chaleur présente une section transversale de forme sensiblement en L et comprend des premier (28) et deuxième (22) pieds, ledit premier pied (28) étant conçu pour être en contact avec ledit radiateur thermique (50) et ledit deuxième pied (22) s'étendant à partir dudit premier pied (28) et présentant une surface plate (25), caractérisés en ce que ledit second pied (22) comporte une partie extrême oblique (24) formant un angle d'au moins 90° avec ladite surface plate (25) ; en ce qu'un élément de chapeau (10) conducteur de la chaleur, ayant une section transversale de forme sensiblement en L, est prévu et comporte des troisième (18) et quatrième pieds, ledit quatrième pied présentant une surface oblique (16) conçue pour s'accoupler avec ladite partie extrême oblique (24) afin que ledit troisième pied (18) soit sensiblement parallèle à ladite surface plate (25) ; et en ce que des moyens de serrage (14) sont prévus sur les surfaces d'accouplement (16, 24) desdits deuxième (22) et quatrième pieds, conçus pour serrer ledit troisième pied (18) vers ladite surface plate (25), de manière que ledit dispositif (30) à semiconducteur puisse être monté entre, et en contact thermique avec, ladite surface plate (25) sur ledit deuxième pied (22) et ledit troisième pied (18) dudit élément de chapeau (10) afin que ledit quatrième pied soit sensiblement parallèle audit premier pied (28).

2. Moyens de montage selon la revendication 1, caractérisés en ce que ledit deuxième pied (22) s'étend à partir dudit premier pied (28) sensiblement à angle droit.

3. Moyens de montage selon la revendication 1, caractérisés en ce que ledit élément de chapeau (10) présente une ouverture allongée (12) traversant ledit quatrième pied, en ce qu'un logement (23) pour organe de fixation est formé dans ledit deuxième pied (22), et en ce que lesdits moyens de serrage comprennent un organe de fixation (14) qui passe à travers ladite ouverture allongée (12) dudit quatrième pied pour entrer en prise avec ledit logement (23) d'organe de fixation et serrer ainsi ledit troisième pied (18) vers ladite surface plate (25).

4. Moyens de montage selon la revendication 1, caractérisés en ce que ledit premier pied (28) présente une autre surface plate (27) conçue pour entrer en contact avec ledit radiateur thermique (50).

5. Moyens de montage selon la revendication 1, caractérisés par le fait que ledit radiateur thermique comprend un châssis métallique (50) ; par une plaquette (40) à circuit imprimé portant des conducteurs (48) conçus pour être connectés à des fils conducteurs électriques (36) partant dudit dispositif (30) a semiconducteur, et traversée d'une ouverture (46) permettant audit deuxième pied (22) de passer ; et par des moyens de fixation (44) conçus pour monter ladite plaquette à circuit imprimé (40) et ledit corps de support (20) sur ledit châssis métallique (50) de manière que ledit dispositif (30) à semiconducteur soit placé à proximité immédiate desdits conducteurs (48).

6. Moyens de montage selon la revendication 1, caractérisés en ce que plusieurs dispositifs à semiconducteurs (30A, 30B) sont montés entre ledit corps de support (20) et ledit élément de chapeau (10A).

FIG. 1

FIG. 2